# EUROPEAN PATENT APPLICATION

(11) **EP 1 249 787 A1**
(43) Date of publication of application: **16.10.2002**
(21) Application number: 01115929.0
(22) Date of filing: 29.06.2001
(51) Int. Cl.: G06K 19/077

(54) **An IC module for a portable electronic device**

(30) Priority: 11.04.2001 JP 2001112462
(71) Applicant: KABUSHIKI KAISHA TOSHIBA, Kawasaki-shi, Kanagawa-ken (JP)
(72) Inventor: Ikeda, Hidetaka, 1-1 Shibaura , Minato-ku, Tokyo (JP)
(74) Representative: Blumbach, Kramer & Partner GbR

(57) **Abstract**

The present invention can be summarized as follows. A contact surface of a copper foil layer on the printed board constituting an IC module is plated with a material having higher durability than its wire bonding surface so that the connection reliability of a terminal of the IC module, the terminal which contacts an external reader/writer, may be improved.

## Description

### CROSS-REFERENCE TO RELATED APPLICATIONS

This application is based upon and claims the benefit of priority from the prior Japanese Patent Application No. 2001-112462, filed on April 11, 2001; the entire contents of which are incorporated herein by reference.

### FIELD OF THE INVENTION

The present invention relates to an IC module to be mounted in a portable electronic device, such as an IC card. The present invention, more particularly, relates to an IC module the connection reliability of a terminal of which is improved, a method for producing the IC module, and a portable electronic device mounted with the IC module.

### BACKGROUND

Devices mounted with a semiconductor integrated circuit (also called 'IC chip') have become widespread. The IC chip has a data storage capacity a hundred times or more as large as that of a magnetic card, and is hardly forged when once it is encoded. Above all, an IC card, which is also called 'smart card', 'chip card', or 'intelligent card', is widely used as a telephone card, an electronic money, etc. The IC card is generally composed of a very thin IC module having an IC chip for recording information built-in and of a plastic card base material having the size of a cash card, the IC module which is mounted in the material.

These IC cards are broadly divided into two categories, namely, 'contact type' and 'non-contact type' according to their read/write interfaces. The contact type IC card has a terminal for electrically and mechanically connecting to an external reader/writer. The reader/writer reads information stored in the IC chip by contacting with a contact surface of the terminal of the IC module, and performs necessary processes.

The following is a conventional method for producing an IC module to be mounted in the contact type IC card. At first, a copper foil layer is formed by bonding copper foil to an insulating printed board having a plurality of wire boding holes at predetermined positions. Next, a terminal having a predetermined pattern, which is composed of a plurality of areas respectively covering the bonding holes, is formed by etching the copper foil layer. And then, both parts of the copper foil layer respectively facing the bonding holes, which are called 'bonding surface', and parts of the layer formed as the pattern are plated with soft gold. The soft gold has small contact resistance and high-conductivity, and it makes easy to perform wire bonding on the boding surface.

However, the soft gilt has a low capacity to resist frictional wear by contact with the reader/writer when the IC card is used. Therefore, there are cases where the gilt comes off during a long time of use and the contact with the terminal becomes worse.

Further, there are cases where the IC card looks unattractive in point of design because the contact surface of the IC module is generally golden independently of the color or design of the card base material in which the IC module is mounted.

### SUMMARY

In view of the foregoing, the present invention solves the problems in the art by providing an IC module. The IC module, which is read and/or written information by contacting with an external apparatus, comprises: an insulating substrate having a plurality of holes at predetermined positions, a conductive layer formed on the bottom of the substrate to cover the holes, the layer which has a pattern composed of a plurality of areas, a first plate layer formed on the top of the conductive layer facing the holes with a first conductive plating material, a second plate layer formed on the bottom of each conductive layer with a second conductive plating material harder than the first plating material, the second plate layer via which the IC module contacts with the apparatus, an integrated circuit element mounted on the top of the substrate, the element which has a predetermined number of pads, and wires connecting the areas and corresponding pads through the holes, respectively.

Also in accordance with the present invention, there is provided a portable electronic device of which base material is mounted with an IC module configured to be read and/or written information by contacting with an external apparatus. The device comprises an insulating substrate having a plurality of holes at predetermined positions, a conductive layer formed on the bottom of the substrate to cover the holes, the layer which has a pattern composed of a plurality of areas a first plate layer formed on the top of the conductive layer facing the holes with a first conductive plating material, a second plate layer formed on the bottom of each conductive layer with a second conductive plating material harder than the first plating material, the second plate layer via which the IC module contacts with the apparatus, an integrated circuit element mounted on the top of the substrate, the element which has a predetermined number of pads, and a wire connecting the areas and corresponding pads through the holes, respectively.

Further in accordance with the present invention, there is provided a method for producing an IC module, which is configured to be read and/or written information by contacting with an external apparatus. The method comprises making a plurality of holes at predetermined positions in an insulating substrate, forming a conductive layer on the bottom of the substrate to cover the holes, the layer which has a pattern composed of a plurality of areas, forming a first plate layer on the top of the conductive layer facing the holes with a first conductive plating material, forming a second plate layer on the bottom of each conductive layer with a second conductive plating material harder than the first plating material, the second plate layer via which the IC module contacts with the apparatus, mounting an integrated circuit element on the top of the substrate, the element which has a predetermined number of pads, and connecting the areas and corresponding pads through the holes, respectively.

### BRIEF DESCRIPTION OF THE DRAWINGS

The accompanying drawings, which are incorporated in and constitute part of this specification, illustrate various embodiments and/or features of the invention and together with the description, serve to explain the principles of the invention. In the drawings:
Fig. 1 is an outside drawing of an example of a contact type IC card consistent with an embodiment of the present invention;
Fig. 2 is a plane view showing an example of pattern form of an IC module terminal consistent with an embodiment of the present invention;
Figs. 3 (a), (b), (c), and (d) are sectional drawings showing the first half of process for producing an IC module substrate;
Figs. 4(a), (b), and (c) are sectional drawings showing the second half of process for producing an IC module substrate;
Figs. 5 (a) and (b) are plane views showing an example of arrangement of copper foil layer on a substrate;
Figs. 6(a), (b), and (c) are sectional drawings showing an example of process for producing an IC module; and
Fig. 7 is a sectional drawing showing a method for mounting an IC module in a card base material.

### DETAILED DESCRIPTION

An embodiment of the present invention will be explained hereunder with reference to the accompanying drawings. The same symbols are respectively assigned to the same parts and redundant explanation will be omitted.

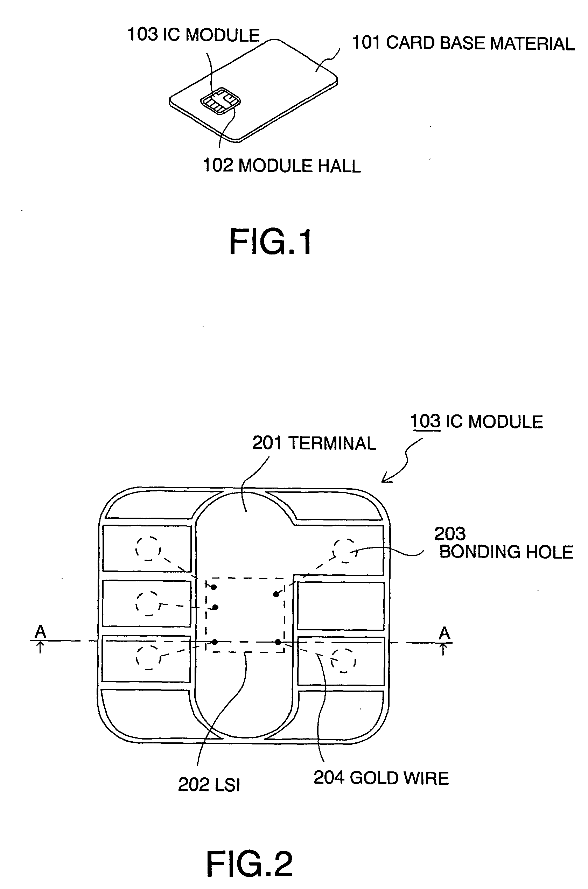

Fig. 1 is an outside drawing of an example of a contact type IC card consistent with an embodiment of the present invention. The IC card is mainly composed of a card base material 101 the surface of which has a concavity, namely, a module hole 102, and an IC module 103 that is mounted and adhered in the concavity. The card base material 101 maybe a mono-layered resin product, a layered resin product, or a laminated resin product.

Fig. 2 is a plane view showing an example of pattern form of a terminal of the IC module 103 shown in Fig. 1. The IC module 103 has a terminal 201 having an IC cardpattern composed of ten independent areas on one side of a printed board 301 (described later) . These areas are plated with palladium, which has high wear resistance and silver color.

On the other side of the printed board 301, a large-scale integrated circuit (LSI) 202 having five pads is mounted by die bonding. These areas are electrically connected to corresponding pads of the LSI 202 by means of gold wire 204 through bonding holes 203 formed at predetermined five positions of the printed board 301, respectively. An external reader/writer (not shown in Fig. 2) comes in contact with the terminal 201 and reads information stored in the LSI 202 to perform a predetermined process.

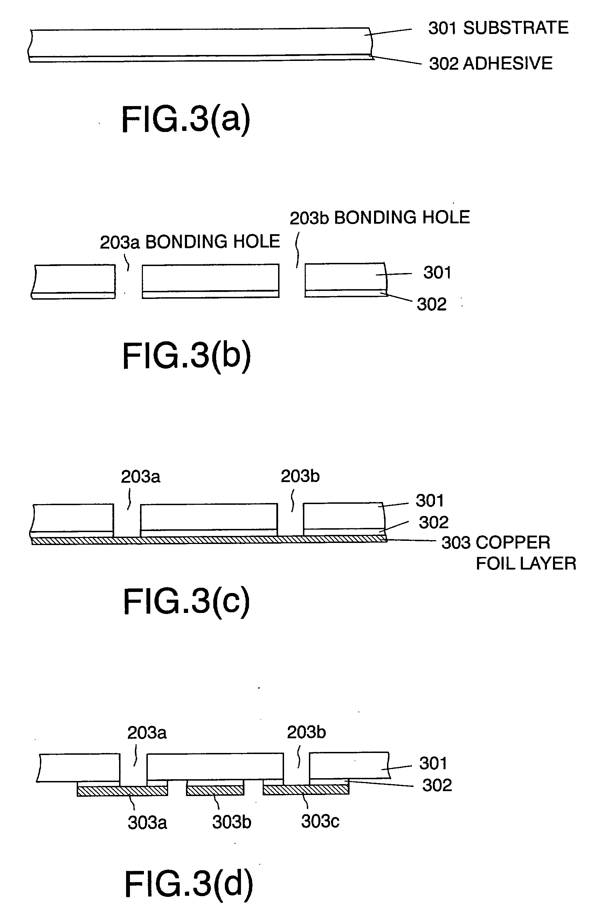

Next, an example of the process for producing a substrate for the IC module 103 will be explained by referring to Figs. 3 (a) - (d) through 5 (a) - (c), which are sectional drawings taken along line A-A in Fig. 2.

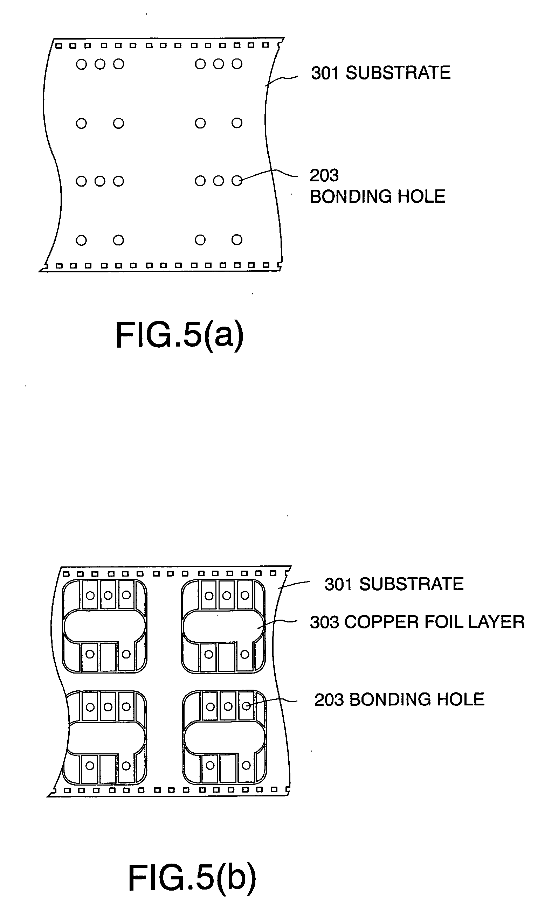

For example, an adhesive 302 having a thickness of approximately 20 µm is coated on the insulating printed board 301 having a thickness of approximately 100 µm, composed of a glass base epoxy resin layered plate (Fig. 3 (a)). Next, bonding holes 203a and 203b having a diameter of approximately 1 µm are formed at predetermined positions of the printed board 301 (Fig. 3(b)). Generally, a plurality of bonding holes 203 corresponding to a plurality of IC modules are formed at predetermined positions as shown in Fig. 5 (a) to mass-produce a plurality of IC modules at a time. And this manufacturing method is called 'chip on board ' method because the LSI 202 is mounted in the printed board 301.

Further, copper foil having a thickness of approximately 35 µm is thermally pressed and adhered on one side of the printed board 301 via the adhesive 302 (Fig. 3(c)). Ten independent areas, namely, copper foil layers 303a, 303b, 303c, etc. to be origins of the terminal 201 shown in Fig. 5(b), are formed on the copper foil layer 303 (Fig. 3(d)) by etching the copper foil layers 303.

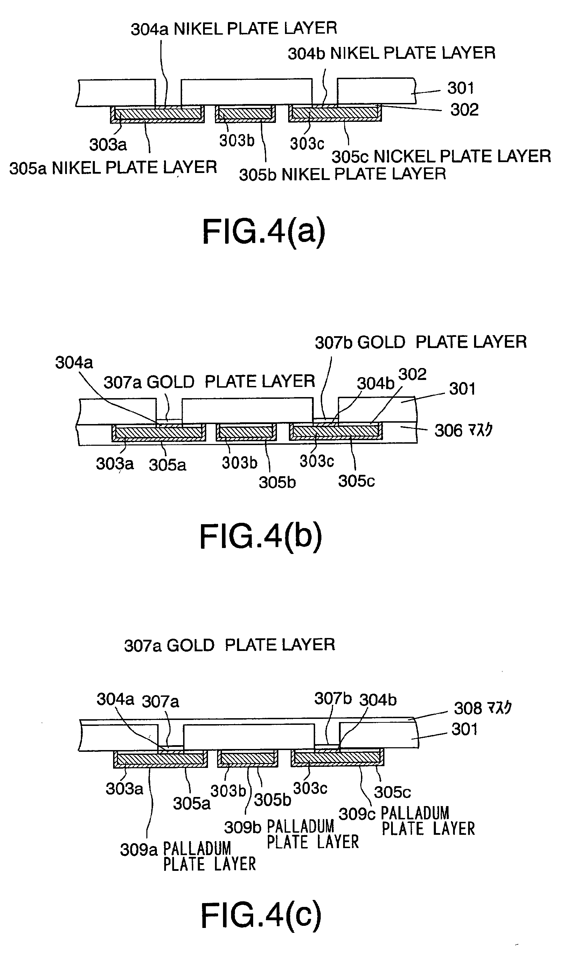

Next, every bonding surfaces and the surfaces of the formed copper foil layers 303a, 303b, and 303c are respectively plated with nickel (Ni) having a thickness of approximately 3 µm ton form Ni plate layers 304a, 304b, 305a, 305b, and 305c (Fig. 4(a)). A mask 306 is formed on the printed board 301 on the side of the terminal 201. And then, the Ni plate layers 304a and 304b, which are bonding surfaces, are plated with soft gold having a thickness of approximately 0.3 µm for wire bonding to respectively form gold plate layers 307a and 307b (Fig. 4(b)).

Finally, a mask 308 is formed on the printed board 301 on the side of the LSI 202. The Ni plate layers 305a, 305b, and 305c are plated with palladium having a thickness of approximately 0.15 µm to respectively form palladium plate layers 309a, 309b, and 309c. And then the substrate producing process for the IC module 103 is finished (Fig. 4(c)).

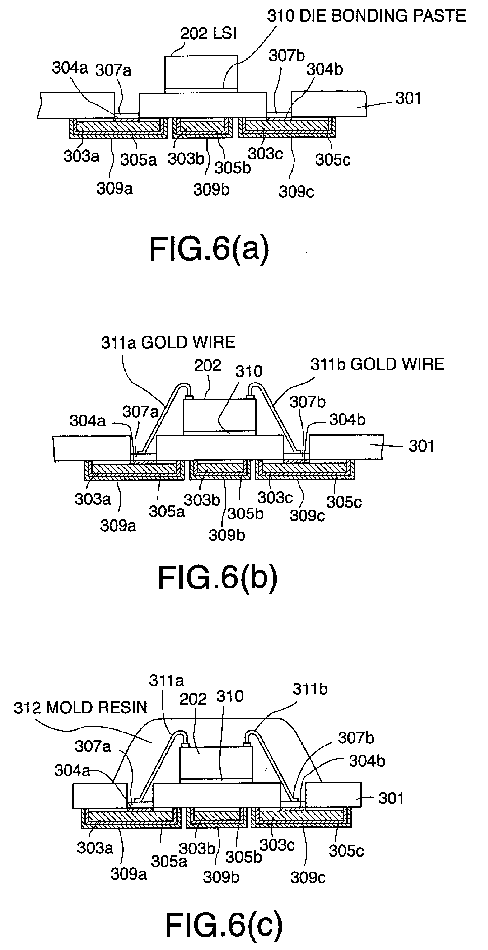

Next, an example of the process for producing an IC module 103 will be explained by referring to Fig. 6 (a) - (c) , which is a sectional drawing taken along line A-A in Fig. 2.

The LSI 203 having a thickness of approximately 250 µm is fixed to the substrate for the IC module 103, which is produced by the process shown in Figs. 3(a)-(d) and 4 (a) - (c) , by die bonding with an insulating adhesive 310, namely, die bonding paste (Fig. 6(a)). Each of the gold plate layers 307a and 307b is electrically connected to the LSI 202 by means of wire bonding with gold wires 311a and 311b having a diameter of approximately 25 µm (Fig. 6(b)).

Further, the LSI 202 and the gold wires 311a and 311b are molded with a resin to form the IC module 103. This molding is called 'transfer mold.' Finally, the substrate for the IC module 103 is cut up into a predetermined size. And then the process for producing the IC module 103 is finished (Fig. 6(c)).

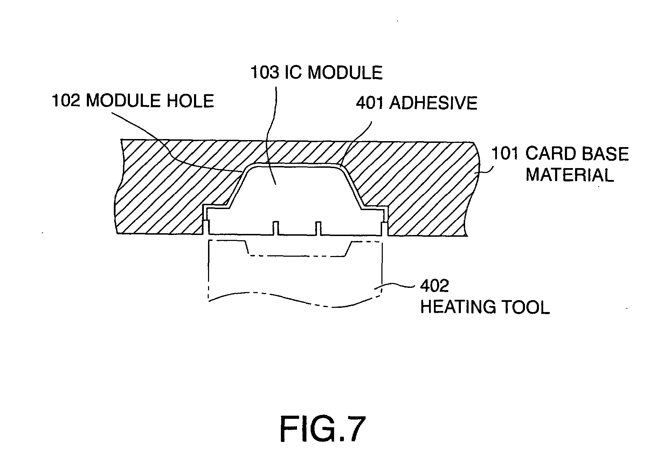

Next, the method for mounting the IC module 103 in the card base material 101 will be explained by referring to Fig. 7. In this case, the module hole 102 is formed in the card base material 102 beforehand so as to fit the IC module 103 into it. An adhesive 401 is applied to the module hole 102 and the IC module 103 is fit into it. Thereafter, the IC module 103 is thermally pressed and fixed by means of a heating tool 402.

According to this embodiment, the bonding surface and the contact surface of the copper foil layer bonded onto the substrate can be plated with a different material. For example, palladium, which has a higher capacity to resist frictional wear than gold, can be used as a plate material. Therefore, both a capacity to resist frictional wear by contact with the reader/writer and the connection reliability of a terminal of the IC module can be improved.

An IC module is generally mounted in a card base material printed with various designs. Therefore, if a color akin to the color of the card base material is selected as a color of the contact surface of the IC module, a beautiful card having a united sense of color as a whole can be obtained.

For example, if an IC module, of which contact surface is plated with palladium, is mounted in a card base material printed in a silver color, an IC card, on one surface of which the card base material and the IC module are unified to a silver color, can be obtained. In the same way, if an IC module, of which contact surface is plated with platinum, is mounted in a card base material printed in a platinum color, an IC card, on one surface of which the card base material and the IC module are unified to a platinum color, can be obtained. This platinum colored IC card may be issued as a platinum card having a high-grade impression.

As mentioned above, according to this embodiment, an IC module of which external appearance is improved can be provided.

The present invention is not limited to the embodiment aforementioned and it may be deformed within a range not deviated from the objects of the present invention. For example, although a gold wire is used as a wire boding wire in this embodiment, any other material, such as aluminum, having good electric conductivity may be selected. Also, various patterns can be adopted for the terminal.

## Claims

1. An IC module configured to be read and/or written information by contacting with an external apparatus, comprising:
an insulating substrate having a plurality of holes at predetermined positions;
a conductive layer formed on the bottom of the substrate to cover the holes, the layer which has a pattern composed of a plurality of areas;
a first plate layer formed on the top of the conductive layer facing the holes with a first conductive plating material;
a second plate layer formed on the bottom of each conductive layer with a second conductive plating material harder than the first plating material, the second plate layer via which the IC module contacts with the apparatus;
an integrated circuit element mounted on the top of the substrate, the element which has a predetermined number of pads; and
wires connecting the areas and corresponding pads through the holes, respectively.

2. The IC module of claim 1, wherein first plate layer is plated with gold and second plating layer is plated with palladium.

3. The IC module of claim 2, further comprising:
a third plate layer formed between the conductive layer and the first palate layer with nickel; and
a fourth plate layer formed between the conductive layer and the second plate layer with nickel.

4. A portable electronic device of which base material is mounted with an IC module configured to be read and/or written information by contacting with an external apparatus, comprising:
an insulating substrate having a plurality of holes at predetermined positions;
a conductive layer formed on the bottom of the substrate to cover the holes, the layer which has a pattern composed of a plurality of areas;
a first plate layer formed on the top of the conductive layer facing the holes with a first conductive plating material;
a second plate layer formed on the bottom of each conductive layer with a second conductive plating material harder than the first plating material, the second plate layer via which the IC module contacts with the apparatus;
an integrated circuit element mounted on the top of the substrate, the element which has a predetermined number of pads; and
a wire connecting the areas and corresponding pads through the holes, respectively.

5. The device of claim 4, wherein first plate layer is plated with gold and second plating layer is plated with palladium.

6. The device of claim 5, further comprising:
a third plate layer formed between the conductive layer and the first palate layer with nickel; and
a fourth plate layer formed between the conductive layer and second plate layer with nickel.

7. The device of claim 4, wherein a color of the second plating material is akin to that of the base material.

8. The device of claim 7, wherein the second plate layer is plated with palladium when the base material is silver.

9. The device of claim 7, wherein the second plate layer is plated with platinum when the base material is platinum color.

10. A method for producing an IC module configured to be read and/or written information by contacting with an external apparatus, comprising:
making a plurality of holes at predetermined positions in an insulating substrate;
forming a conductive layer on the bottom of the substrate to cover the holes, the layer which has a pattern composed of a plurality of areas;
forming a first plate layer on the top of the conductive layer facing the holes with a first conductive plating material;
forming a second plate layer on the bottom of each conductive layer with a second conductive plating material harder than the first plating material, the second plate layer via which the IC module contacts with the apparatus;
mounting an integrated circuit element on the top of the substrate, the element which has a predetermined number of pads; and
connecting the areas and corresponding pads through the holes, respectively.
